(19) Europäisches Patentamt
European Patent Office
Office européen des brevets

(11) EP 3 674 755 A1

(12) EUROPEAN PATENT APPLICATION
published in accordance with Art. 153(4) EPC

(43) Date of publication:
01.07.2020 Bulletin 2020/27

(51) Int Cl.:
G02B 5/00 (2006.01)   F21S 2/00 (2016.01)
F21V 5/00 (2018.01)   H01L 31/054 (2014.01)
H01L 33/60 (2010.01)   H02S 40/22 (2014.01)

(21) Application number: 18847684.0

(22) Date of filing: 04.07.2018

(86) International application number:
PCT/JP2018/025370

(87) International publication number:
WO 2019/039101 (28.02.2019 Gazette 2019/09)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 25.08.2017 JP 2017162719

(71) Applicants:
• Kabushiki Kaisha Toshiba
Minato-ku
Tokyo 105-0023 (JP)

• Toshiba Materials Co., Ltd.
Yokohama-shi, Kanagawa 235-8522 (JP)

(72) Inventor: OHNO, Hiroshi
Tokyo 105-0023 (JP)

(74) Representative: Hoffmann Eitle
Patent- und Rechtsanwälte PartmbB
Arabellastraße 30
81925 München (DE)

(54) OPTICAL ELEMENT, LIGHTING DEVICE, AND LIGHT CONDENSER

(57) According to one embodiment, an optics includes an incidence part (130), a first internal total reflection part (110), and an emission part (140). The incidence part (130) is where a light beam enters. The first internal total reflection part (110) internally totally reflects a light beam from the incidence part (130). The emission part (140) emits light beam internally totally reflected by the first internal total reflection part (110). The first internal total reflection part (110) includes a first ridge part (111). The first ridge part (110) extends radially from a central axis (A1) of the optics. The cross-sectional shape of the first ridge part (110) changes according to a distance from the central axis (A1).

F I G. 1

## Description

FIELD

Embodiments of the present invention relate to a high-efficiency optics, a lighting device, and a condenser.

BACKGROUND

Generally, a lighting device requires light distribution control, instrument efficiency (ratio of a light flux used as illumination to a total light flux of a light source), and compactness. Conventionally, as a method for realizing a compact lighting device, a method using a reflecting mirror is known. In addition, particularly in illumination for medical use, the uniformity of color of illumination light on an irradiated surface is also required.

BRIEF DESCRIPTION OF THE DRAWING(S)

FIG. 1 is a schematic diagram illustrating an outline of an appearance and a configuration example of a lighting device according to a first embodiment.

FIG. 2 is a schematic diagram illustrating an outline of a configuration example and an example of a light beam path in a cross-section passing through a central axis of the lighting device according to the first embodiment.

FIG. 3 is a schematic diagram for describing an example of a light beam path in a part of an optics according to the first embodiment.

FIG. 4 is a schematic diagram illustrating a state of a part of the optics according to the first embodiment illustrated in FIG. 3, when viewed from the lateral surface side.

FIG. 5 is a schematic diagram illustrating a state of a part of the optics according to the first embodiment illustrated in FIG. 3, when viewed from the emission surface side.

FIG. 6 is a schematic diagram illustrating an outline of an appearance and a configuration example of a lighting device according to a second embodiment and an example of a light beam path.

FIG. 7 is a schematic diagram of an outline of an appearance and a configuration example in the vicinity of a first internal total reflection part of the lighting device according to the second embodiment and an example of a light beam path.

FIG. 8 is a schematic diagram for describing an example of a light beam path in an optics according to the second embodiment.

FIG. 9 is a schematic diagram illustrating an outline of an appearance and a configuration example when the lighting device according to the second embodiment includes two light sources and an example of a light beam path.

FIG. 10 is a schematic diagram for describing an analysis model when the lighting device according to the second embodiment includes two light sources.

FIG. 11 is a diagram illustrating an analysis result of illuminance distribution on an irradiated surface of illumination light by a blue LED when the lighting device according to the second embodiment includes two light sources.

FIG. 12 is a diagram illustrating an analysis result of illuminance distribution at a position Y = 0 on an irradiated surface of illumination light by a blue LED when the lighting device according to the second embodiment includes two light sources.

FIG. 13 is a diagram illustrating an analysis result of illuminance distribution on an irradiated surface of illumination light by a red LED when the lighting device according to the second embodiment includes two light sources.

FIG. 14 is a diagram illustrating an analysis result of illuminance distribution at a position Y = 0 on an irradiated surface of illumination light by a red LED when the lighting device according to the second embodiment includes two light sources.

FIG. 15 is a diagram illustrating an analysis result of illuminance distribution on an irradiated surface of illumination light by two light sources when the lighting device according to the second embodiment includes two light sources.

FIG. 16 is a diagram illustrating an analysis result of illuminance distribution at a position Y = 0 on an irradiated surface of illumination light by two light sources when the lighting device according to the second embodiment includes two light sources.

FIG. 17 is a schematic diagram illustrating an outline of an appearance and a configuration example of a lighting device according to a first modification.

DETAILED DESCRIPTION

An optics according to the present embodiment includes an incidence part, a first internal total reflection part, and an emission part. The incidence part is where a light beam enters. The first internal total reflection part internally totally reflects a light beam from the incidence part. The emission part emits light beam internally totally reflected by the first internal total reflection part. The first internal total reflection part includes a first ridge part. The first ridge part extends radially from a central axis of the optics. The cross-sectional shape of the first ridge part changes according to a distance from the central axis.

Hereinafter, embodiments of the present invention will be described with reference to the drawings. Note that the drawings are schematic or conceptual, and the relationship between the thickness and the width of each portion, the ratio of the sizes between the portions, and the like are not necessarily the same as the actual ones.

In addition, even in the case of representing the same portion, the dimensions or ratios of the portions may be represented differently depending on the drawings. In the present specification and each drawing, the same reference numerals are assigned to the same elements as those described above with reference to the previous drawings, and detailed descriptions thereof will be omitted as appropriate. In addition, the description of vertical, orthogonal, parallel, horizontal, or the like is not necessarily limited to a case where it is strictly vertical, orthogonal, parallel, or horizontal, and they may be substantially vertical, substantially orthogonal, substantially parallel, or substantially horizontal, respectively.

(First Embodiment)

Generally, a lighting device requires light distribution control, instrument efficiency, and compactness. Here, the instrument efficiency indicates a ratio of a luminous flux used as illumination to a total luminous flux of a light source. Conventionally, as a method for realizing a compact lighting device, a method using a reflecting mirror is known. If a light beam path is folded by using a reflecting mirror, a compact lighting device can be realized. However, the reflecting mirror absorbs a part of energy of illumination light. Therefore, when the reflecting mirror is used to fold the light beam path, energy loss occurs and the instrument efficiency of the lighting device is lowered.

Therefore, in the present embodiment, an optics for changing the light beam direction of the illumination light by total reflection and folding the light beam path and a lighting device in which energy loss is reduced by using the optics will be described.

Hereinafter, the lighting device according to the present embodiment will be described in detail with reference to the drawings. The technique according to the present embodiment realizes illumination (widely distributed illumination) that can illuminate a wide azimuth. Note that illumination of wide light distribution light can also be expressed as illumination with a large light distribution angle.

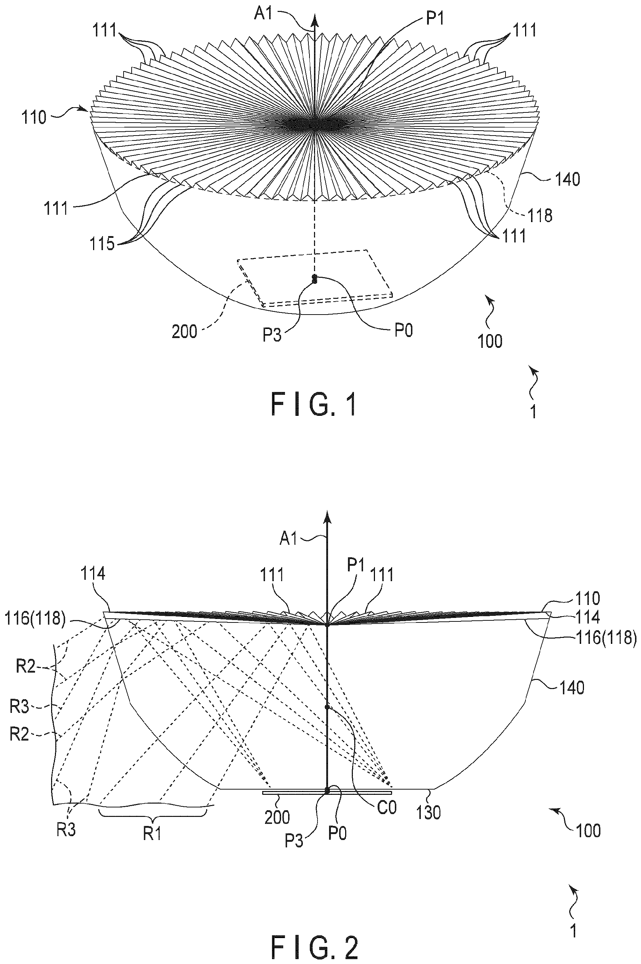

First, the configuration of the lighting device according to the present embodiment will be described. FIG. 1 is a schematic diagram illustrating an outline of an appearance and a configuration example of the lighting device according to the present embodiment. In addition, FIG. 2 is a schematic diagram illustrating an outline of a configuration example and an example of a light beam path in a cross-section passing through a central axis of the lighting device according to the present embodiment. In FIG. 2, as an example, light beam paths of a light beam R1, a light beam R2, and a light beam R3 are illustrated. As illustrated in FIGS. 1 and 2, the lighting device 1 according to the present embodiment includes an optics 100 and a light source 200.

As illustrated in FIG. 2, the optics 100 according to the present embodiment includes an incidence part 130 and an emission part 140. The incidence part 130 has an interface (incidence plane) on which illumination light is incident on the optics 100. The emission part 140 has an interface (emission surface) in which the illumination light incident from the incidence part 130 to the inside of the optics 100 changes the light beam direction in the inside of the optics 100 and is then emitted to the outside of the optics 100.

Here, for the purpose of the following description, the central axis A1 of the optics 100 is defined as an axis that passes through a center P0 of the incidence part 130 and is orthogonal to the incidence plane of the incidence part 130. At this time, the central axis A1 passes through a center C0 of the optics 100. A direction parallel to the central axis A1 is defined as a Z direction, and a plane parallel to the incidence plane of the incidence part 130 is defined as an XY plane. In addition, a direction from the center P0 of the incidence part 130 to the center C0 of the optics 100 is defined as a Z+ direction.

As illustrated in FIGS. 1 and 2, for example, the optics 100 according to the present embodiment has an outer shape rotationally symmetrical with respect to the central axis A1, like a bowl. However, the shape of the optics 100 is not limited to the rotationally symmetrical shape and may be any shape. The shape of the optics 100 may be determined, for example, based on a relative position between the optics 100 and the light source 200 or the object to be illuminated. The shape of the optics 100 may be determined according to the required light distribution angle of the illumination light. In addition, although the optics 100 according to the present embodiment is solid, it may be a shell structure (hollow) having a cavity inside.

It is assumed that a material (substance) constituting the optics 100 is transparent to light (illumination light). For example, the material may be a transparent resin such as acryl, polycarbonate, silicone, or may be glass. When the glass is used as the material, there is an advantage that improvement in heat resistance of the optics 100 can be expected. In the present embodiment, it is assumed that the material of the optics 100 is an acrylic resin having a refractive index (n) of 1.49.

The light source 200 according to the present embodiment is disposed on the outer side (Z- side) of the optics 100 opposite to the incidence part 130 of the optics 100. The light source 200 has a light emitting surface that emits the illumination light. The shape of the light emitting surface according to the present embodiment is rectangular, but is not limited thereto. The shape of the light emitting surface may be, for example, a circular shape, a polygonal shape, or an arbitrary shape. The light emitting surface is disposed, for example, parallel to the incidence part 130. The light source 200 is disposed, for example, so that the center P3 of the light emitting surface is positioned on the central axis A1. The light emitting surface is disposed, for example, at a position in contact with the incidence part 130 of the optics 100, but may be disposed at a predetermined distance away from the incidence part 130 of the optics 100 in the Z- direction. The illumination light emitted from the light emitting surface illuminates the incidence part 130 of the optics 100. The light source 200 according to the present embodiment is a light emitting diode (LED), but is not limited thereto. The light source 200 may be, for example, a filament light source or the like.

The optics 100 according to the present embodiment further includes a first internal total reflection part 110 that totally reflects rays incident from the incidence part 130 inside the optics 100. The first internal total reflection part 110 is disposed at a position facing the incidence part 130. The center P1 of the first internal total reflection part 110 is located on the central axis A1 of the optics 100. The first internal total reflection part 110 has a first ridge part 111 on the side facing the incidence part 130. Note that the side facing the incidence part 130 of the first internal total reflection part 110 can also be expressed as the Z- side and the inside (center C0) side of the optics 100.

The first ridge part 111 is disposed in the first internal total reflection part 110 so as to extend radially from the central axis A1. In addition, a plurality of first ridge parts 111 is provided adjacent to each other. That is, the first ridge parts 111 adjacent to each other constitute a first trough part 115. This can also be expressed as follows: a pair of first trough parts 115 are provided on both sides with the first ridge part 111 being interposed therebetween.

Hereinafter, a virtual plane defined by a first bottom 116 of the pair of first trough parts 115 is defined as a first imaginary surface 118. Note that the first bottom 116 can also be expressed as a boundary between first ridge parts 111 adjacent to each other. In the present embodiment, the first imaginary surface 118 includes the first bottom 116 of all the first trough parts 115 existing in the first internal total reflection part 110.

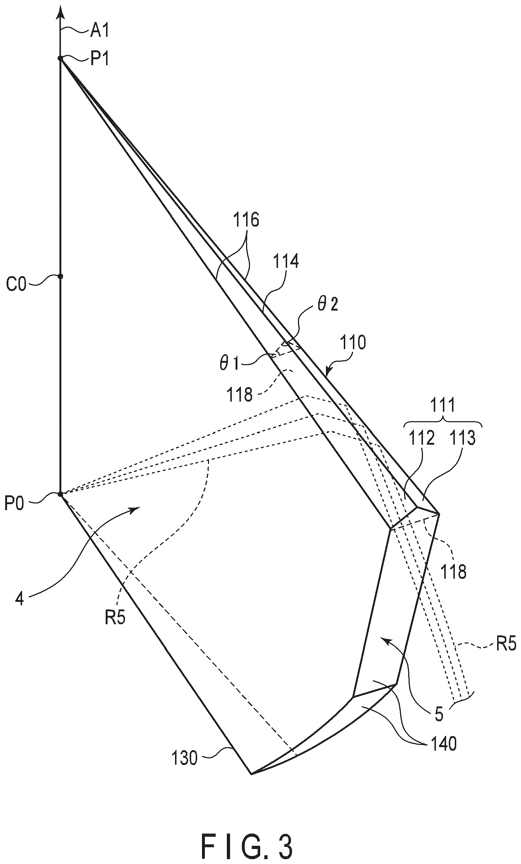

As illustrated in FIG. 3, the first ridge part 111 includes a first total reflection surface 112 having a first angle θ1 with respect to a first imaginary surface 118, and a second total reflection surface 113 having a second angle θ2 with the first total reflection surface 112. Note that the second angle θ2 corresponds to the apex angle of the first ridge part 111. In addition, an intersection line of the first total reflection surface 112 or the second total reflection surface 113 and the first imaginary surface 118 corresponds to the first bottom 116. In other words, the first bottom 116 corresponds to an intersection line of the first total reflection surface 112 of one first ridge part 111 and the second total reflection surface 113 of the other first ridge part 111 adjacent to the one first ridge part 111. In addition, the intersection line of the first total reflection surface 112 and the second total reflection surface 113 corresponds to a first top 114 of the first ridge part 111.

The first ridge part 111 defined as described above has an inverted V-shaped cross-sectional shape in a virtual cross-section orthogonal to the first bottom 116 and the first imaginary surface 118. In addition, the first ridge part 111 is convex in a direction (Z+ direction) away from the center C0 of the optics 100. That is, the intersection lines of the virtual cross-section, and the first imaginary surface 118, the first total reflection surface, and the second total reflection surface constitute an isosceles triangle on the virtual cross-section. At this time, the first angle θ1 and the second angle θ2 are each one of the interior angles of the isosceles triangle. However, in the present embodiment, it is assumed that a length of the intersection line of the virtual cross-section, and the first total reflection surface 112 and the second total reflection surface 113 is equal on the virtual cross-section.

The cross-sectional shape of the first ridge part 111 defined as described above changes according to the distance from the central axis A1 (light source 200). That is, the distance between the first top 114 of the first ridge part 111 and the first imaginary surface 118 is larger as the distance from the central axis A1 increases. This can be expressed as follows: as the distance from the central axis A1 increases, the height of the first ridge part 111 increases, or the widths of the first total reflection surface 112 and the second total reflection surface 113 increase. Here, the width of the first total reflection surface 112 or the second total reflection surface 113 is a distance between the first top 114 of the first ridge part 111 and the first bottom 116 of the first trough part 115 adjacent to the first ridge part 111. On the other hand, it is assumed that the apex angle (second angle θ2) of the first ridge part 111 is constant regardless of the distance from the central axis A1.

As described above, the first ridge part 111 according to the present embodiment is positioned on the first imaginary surface 118. The first imaginary surface 118 has a shape troughed in a substantially conical shape on the center C0 side (Z- side) of the optics 100. At this time, the center of the first imaginary surface 118 remains positioned on the central axis A1.

From the configuration described above, the angle of the first total reflection surface 112 with respect to the incidence plane of the incidence part 130 is expressed by the sum of the angle of the first imaginary surface 118 (first bottom 116) with respect to the incidence plane of the incidence part 130 and the first angle θ1. As described above, the cross-sectional shape of the first ridge part 111 changes according to the distance from the light source 200 (central axis A1).

Here, the operation of the lighting device 1 according to the present embodiment will be described with reference to the drawings. FIG. 2 illustrates an example of the light beam path in the cross-section on the central axis A1 of the optics 100. In the optics 100 according to the present embodiment, the central axis A1 passes through the center C0 of the optics 100, the center P0 of the incidence part 130, and the center P1 of the first internal total reflection part 110. In addition, the light source 200 is disposed so that the center P3 of the light source 200 is positioned on the central axis A1. The light beam emitted from the light emitting surface of the light source 200 irradiates the incidence part 130. The light beam is incident on the inside of the optics 100 from the incidence part 130. The light beam incident on the inside of the optics 100 passes through the inside of the optics 100 and reach the first internal total reflection part 110.

Here, it is considered a case where the first ridge part 111 is not provided in the first internal total reflection part 110. At this time, both the first angle θ1 and the second angle θ2 are 0°, and the first total reflection surface 112 and the second total reflection surface 113 provided in the first internal total reflection part 110 are disposed on the first imaginary surface 118.

Generally, in the case where the incidence angle on the incidence plane is equal to or smaller than a critical angle θc, the light beam is transmitted through the incidence plane without being totally reflected.

Here, the critical angle θc is expressed as follows by using the refractive index n.

$$\theta_C = \sin^{-1}\left(\frac{1}{n}\right) \quad \dots \text{Formula (1)}$$

That is, the light beam of which incidence angle on the first internal total reflection part 110 (first imaginary surface 118) is equal to or smaller than the critical angle θc passes through the first internal total reflection part 110 and is emitted to the outside of the optics 100. Therefore, the light beam emitted from the optics is a light beam of narrow light distribution having a small angle with respect to the central axis A1. The angle formed between the light beam and the central axis A1 is 90 degrees or less.

Therefore, in the case where the first ridge part 111 is not provided in the first internal total reflection part 110, many light beams incident on the first internal total reflection part 110 (first imaginary surface 118) are not internally totally reflected, and the light beams pass through the first internal total reflection part 110 and are emitted to the outside of the optics 100. Of course, for example, as illustrated in the light beam R2 in FIG. 2, the light beam incident on the first internal total reflection part 110 (first imaginary surface 118) at an angle exceeding the critical angle θc can be totally reflected even if the first ridge part 111 is not provided in the first internal total reflection part 110. However, the light beam incident from the incidence part 130 to the inside of the optics 100 passes through the first internal total reflection part 110 and is emitted to the outside, or is totally reflected by the first internal total reflection part 110 and is emitted from the emission part 140 to the outside. Therefore, in either case, the instrument efficiency as the lighting device 1 is low.

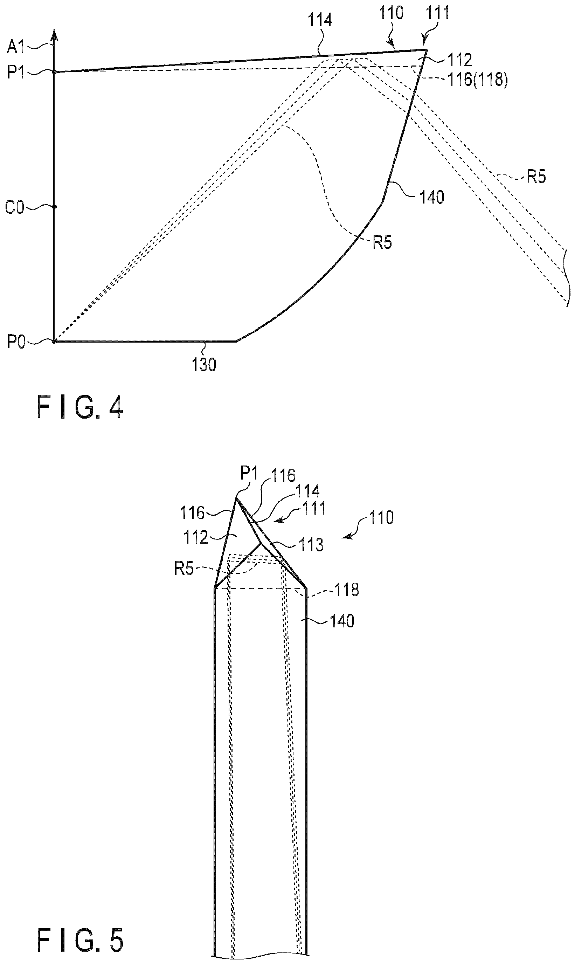

On the other hand, the first internal total reflection part 110 according to the present embodiment is provided with the first ridge part 111. Hereinafter, this case will be described with reference to FIGS. 3 to 5. FIG. 3 is a perspective cross-sectional view of an optics piece in which the optics 100 according to the present embodiment illustrated in FIG. 1 is cut along the pair of first bottoms 116 and the central axis A1. In addition, FIG. 4 illustrates a view of the optics piece of FIG. 3 as viewed from a direction orthogonal to a cross-section 4. In addition, FIG. 5 illustrates a view of the optics piece of FIG. 3 when viewed from a cross-section 5 side. In addition, FIGS. 3 to 5 illustrate a part of the light beams (light beams including the light beam R5) incident on the inside of the optics 100 from the center P0 of the incidence part 130.

At this time, the first angle θ1 is set so that the light beams incident from the incidence part 130 can be incident on the first total reflection surface 112 at an angle equal to or larger than the critical angle θc. In addition, the second angle θ2 (apex angle of the first ridge part 111) is set so that the light beams totally reflected by the first total reflection surface 112 can be incident on the second total reflection surface 113 at an angle equal to or larger than the critical angle θc.

With such a configuration, as illustrated in FIGS. 3 to 5, the light beams are continuously totally reflected on the first total reflection surface 112 and the second total reflection surface 113. Therefore, the light beams incident on the first internal total reflection part 110 from the incidence part 130 are folded back in the first internal total reflection part 110, without absorption loss such as reflection by mirror. In addition, the light beam folded in the first internal total reflection part 110 is emitted from the emission part 140, like the light beam R1, the light beam R2, and the light beam R3 in FIG. 2. As described above, the light beam emitted from the optics 100 according to the present embodiment is a light beam of wide light distribution having a large angle with respect to the central axis A1. The angle formed between the light beam and the central axis A1 is 90 degrees or more.

According to the optics 100 and the lighting device 1 including the optics 100 according to the present embodiment, the following can be said.

The optics 100 according to the present embodiment includes the incidence part 130 on which the light beams are incident, the first internal total reflection part 110 which internally totally reflects the light beams incident from the incidence part 130, and the emission part 140 from which the light beams internally totally reflected by the first internal total reflection part 110 are emitted. The first internal total reflection part 110 has the first ridge part 111 extending radially from the central axis A1 of the optics 100. The cross-sectional shape of the first ridge part 111 changes according to the distance from the central axis A1. According to this configuration, the light beams incident from the incidence part 130 can be totally reflected twice in the first ridge part 111. Therefore, it is possible to totally reflect the light beams without generating energy loss, like the reflection using the mirror. That is, if using the optics 100 according to the present embodiment, the compactness of the optics can be realized by folding the light beam, and the energy loss can also be reduced.

In the optics 100 according to the present embodiment, the first internal total reflection part 110 includes the pair of first trough parts 115 on both sides with the first ridge part 111 being interposed therebetween. The first ridge part 111 includes the first total reflection surface 112 having the first angle θ1 with respect to the first imaginary surface 118 defined by the first bottom 116 of the pair of first trough parts 115, and the second total reflection surface 113 having the second angle θ2 with respect to the first total reflection surface 112. According to this configuration, the same effect as described above can be obtained by an inverted V-shaped first ridge part 111 having a simple shape. In addition, the first ridge part 111 and the first trough part 115 are alternately arranged adjacent to each other. Therefore, the light beams totally reflected by the first internal total reflection part 110 may be incident in any direction from any position of the incidence part 130.

In the optics 100 according to the present embodiment, the first top 114 of the first ridge part 111 is the intersection line of the first total reflection surface 112 and the second total reflection surface 113, and the length from the first top 114 to the first imaginary surface 118 increases with the distance from the central axis A1. According to this configuration, since the angle between the first total reflection surface 112 and the second total reflection surface 113 can be set according to the distance from the light source 200 (central axis A1), the light beam can be totally reflected properly.

In the optics 100 according to the present embodiment, the first imaginary surface 118 has an apex on the central axis A1 and is recessed in a substantially conical shape on the center C0 side of the optics 100. According to this configuration, the light beams emitted from the light source 200 in the direction of the central axis A1, that is, in the Z+ direction can also be internally totally reflected.

In the optics 100 according to the present embodiment, the first angle θ1 is set so that the incidence angle of the light beam incident from the incidence part 130 with respect to the first total reflection surface 112 exceeds the critical angle θc. As described above, since the angle of the first total reflection surface 112 can be set with respect to the light beam arriving from the incidence part 130 to the first internal total reflection part 110, the light beam can be totally reflected properly.

In the optics 100 according to the present embodiment, the second angle θ2 is constant, and the second angle θ2 is set so that the light beams totally reflected by the first total reflection surface 112 are further totally reflected on the second total reflection surface 113. That is, the second angle θ2 is set so that the incidence angle of the light beams totally reflected by the first total reflection surface 112 to the second total reflection surface 113 exceeds the critical angle θc. As described above, since the angle of the second total reflection surface 113 can be set with respect to the light beam which arrives from the first total reflection surface 112 to the second total reflection surface 113, the light beams can be continuously totally reflected properly twice.

The lighting device 1 according to the present embodiment includes the optics 100 and the light source 200. According to this configuration, the compact lighting device 1 with high instrument efficiency is realized by the above-described effects.

In the lighting device 1 according to the present embodiment, the incidence part 130 and the first internal total reflection part 110 face each other. Therefore, since the light beams emitted from the light source 200 and incident on the incidence part 130 can be internally totally reflected by the first internal total reflection part 110, the above-described effects can be obtained.

In the lighting device 1 according to the present embodiment, the light source 200 is an LED. According to this configuration, in addition to the above-described effects, the lighting device 1 with even lower power consumption is realized.

In the lighting device 1 according to the present embodiment, the angle between the central axis A1 and the light beam incident on the incidence part 130 is small as compared to the angle between the central axis A1 and the light beam emitted from the emission part 140. As described above, the lighting device 1 according to the present embodiment has the effect of realizing widely distributed illumination in addition to the above-described effects.

Note that, in the present embodiment, the case where the first ridge part 111 of the first internal total reflection part 110 has an inverted V shape will be described as an example, but the present invention is not limited thereto. The first ridge part 111 may have any shape as long as the incident light beam can be continuously totally reflected twice. The first ridge part 111 may have, for example, a U-shape.

Note that, in the present embodiment, the case where the cross-sectional shape of the first ridge part 111 changes according to the distance from the central axis A1 (light source 200) has been described as an example, but the cross-sectional shape may be constant if two consecutive internal total reflections can be realized, and the first imaginary surface may not be recessed in a substantially conical shape. In addition, the second angle θ2 (apex angle of the first ridge part 111) may not be constant.

Note that, in the present embodiment, the member that totally reflects the light beam has been described by expressing it as the first ridge part 111, but the present invention is not limited thereto. For example, the first ridge part 111 may be expressed as a first groove part.

Note that, in the present embodiment, the single-layer optics 100 made of the single material has been described as an example, but the present invention is not limited thereto. The optics 100 may have a laminated structure. That is, a plurality of substances may be used as the material of the optics 100, or the material may be different for each layer. In addition, the optics 100 may have, for example, a structure in which the first internal total reflection part 110, the incidence part 130, and the emission part 140, which are individually formed, are combined with each other.

Note that, in the present embodiment, the optics 100 including the plurality of first ridge parts 111 has been described, but the present invention is not limited thereto. For example, as illustrated in FIG. 3, the optics piece having one first ridge part 111 can also be used as the optics that can reflect light beams without substantial energy loss.

(Second Embodiment)

Hereinafter, the lighting device 1 according to the present embodiment will be described in detail with reference to the drawings. Here, the difference from the first embodiment will be mainly described, the same parts will be denoted by the same reference numerals, and description thereof will be omitted.

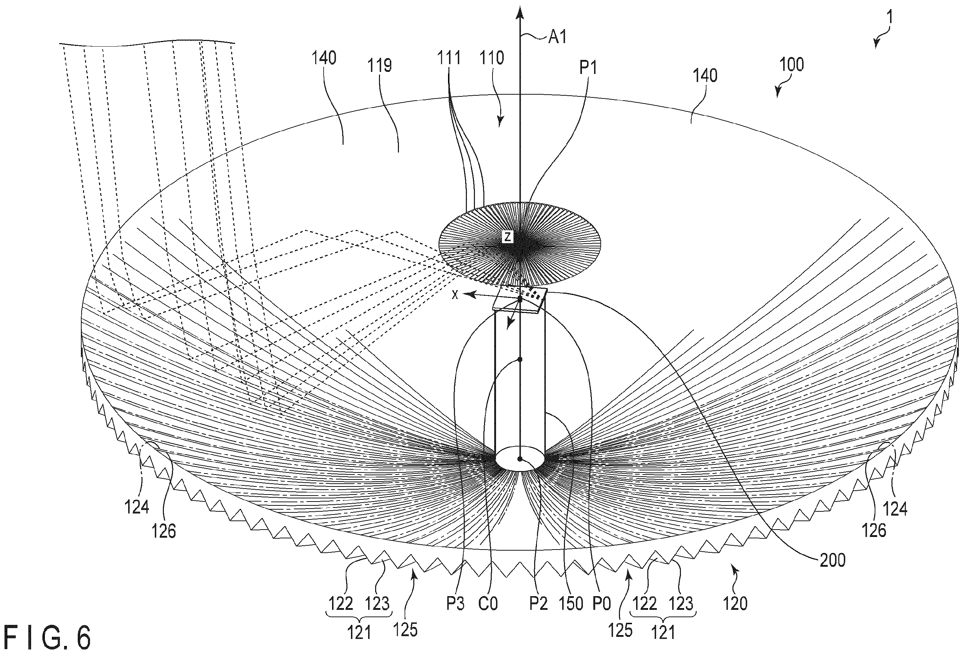

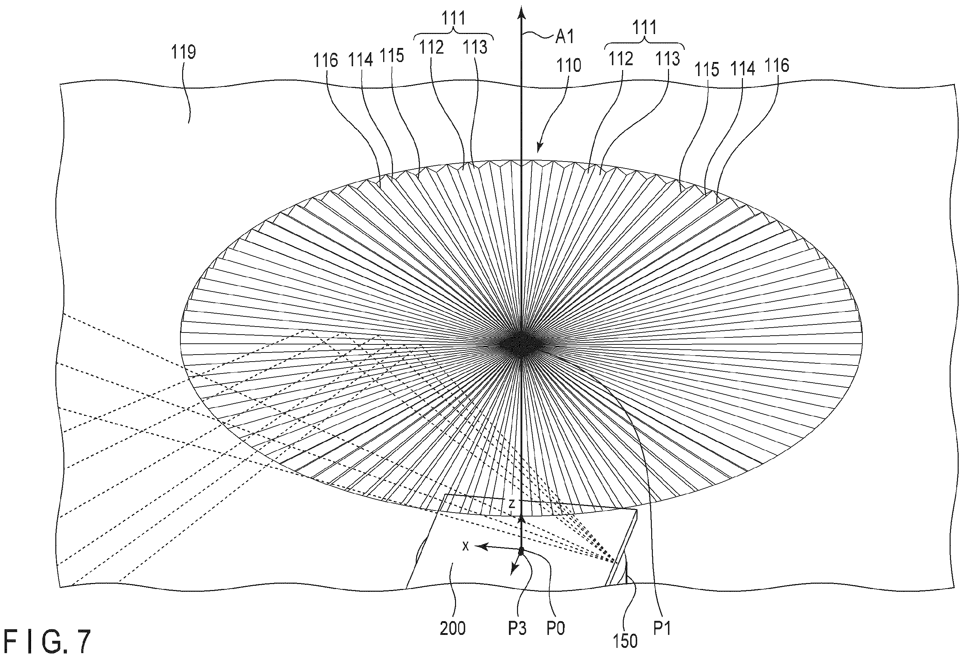

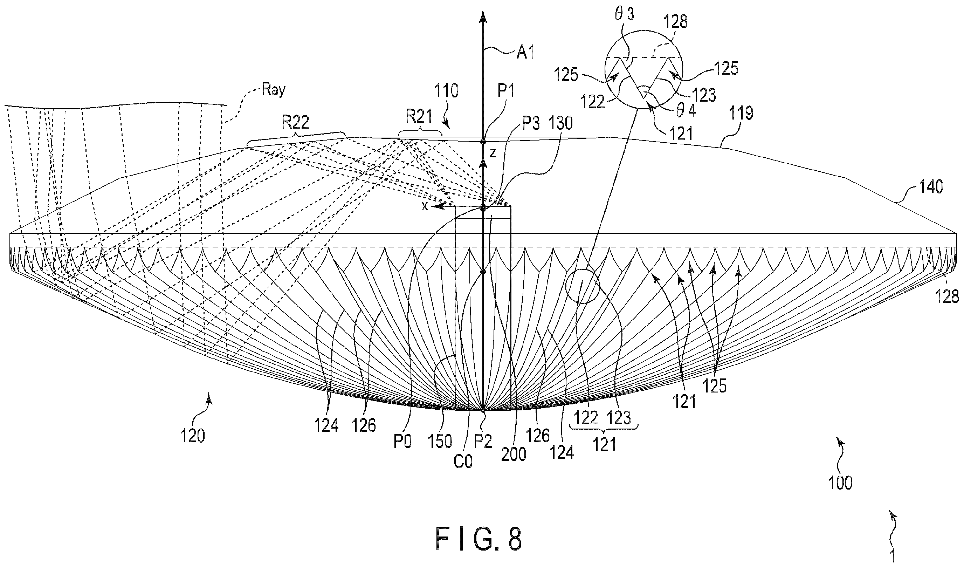

First, the configuration of the lighting device 1 according to the present embodiment will be described. FIG. 6 schematically illustrates a configuration example of the lighting device 1 according to the present embodiment. Since the optics 100 has translucency, the second ridge part 121 and the second trough part 125 formed on the bottom surface side (second internal total reflection part 120 to be described later) are seen through from above in FIG. 6. Here, for the sake of clarity, the second top 124 of the second ridge part 121 which is seen through is indicated by a dashed line, and similarly, the second bottom 126 of the second trough part 125 which is seen through is indicated by a solid line. In addition, FIG. 7 schematically illustrates an outline of a configuration example in the vicinity of the first internal total reflection part 110 according to the present embodiment. FIGS. 6 and 7 schematically illustrate an example of the light beam path in addition to the outline of the configuration example of the lighting device 1. In addition, FIG. 8 illustrates a side view of the lighting device 1 according to the present embodiment. FIG. 8 also illustrates an example of the light beam path on the X-Z plane passing through the central axis A1.

As illustrated in FIG. 8, the optics 100 according to the present embodiment has an outer shape rotationally symmetrical with respect to the central axis A1, such as a convex lens. The outer shape of the optics 100 according to the present embodiment can also be expressed as a disk shape in which the thickness decreases with the distance from the central axis A1. It is assumed that the optics 100 is solid.

As illustrated in FIGS. 6 to 8, the first internal total reflection part 110 according to the present embodiment is disposed on the Z+ side of the optics 100. In addition, the first internal total reflection part 110 according to the present embodiment includes a first ridge part 111 to a position apart from the central axis A1 by a predetermined distance. This is because, at the position apart from the central axis A1 by the predetermined distance or more, the angle formed by the light beam incident from the incidence part 130 and the central axis A1 increases, and the incidence angle of the light beam on the first internal total reflection part 110 on the Z- side surface of the optics 100 exceeds the critical angle $\theta c$. Hereinafter, the Z- side (center C0 side of the optics 100) of the optics 100 of the first internal total reflection part 110 and the surface of the periphery of the first ridge part 111 are defined as a peripheral total reflection surface 119 of the first internal total reflection part 110. That is, in the optics 100 according to the present embodiment, the light beam is internally totally reflected at the first ridge part 111 or the peripheral total reflection surface 119.

In addition, as illustrated in FIGS. 6 and 8, the optics 100 according to the present embodiment has a blind hole 150. The shape of the blind hole 150 is, for example, a columnar shape, but is not limited thereto. For example, the blind hole 150 may be prismatic, conical, or pyramidal. The blind hole 150 is formed in the Z+ direction from the side facing the first internal total reflection part 110. The incidence part 130 according to the present embodiment is positioned at the bottom of the blind hole 150. That is, similarly to the optics 100 according to the first embodiment, the incidence part 130 and the first internal total reflection part 110 face each other.

In addition, the light source 200 according to the present embodiment is disposed at the bottom of the blind hole 150. The light source 200 according to the present embodiment is disposed so that the light emitting surface is in contact with the bottom of the blind hole 150. That is, as in the first embodiment, the light emitting surface of the light source 200 is directed toward the Z+ side and faces the first internal total reflection part 110.

The optics 100 according to the present embodiment further includes a second internal total reflection part 120 which further totally reflects the light beams totally reflected by the first internal total reflection part 110 inside the optics 100. The second internal total reflection part 120 is disposed at a position facing the first internal total reflection part 110. The center P2 of the second internal total reflection part 120 is positioned on the central axis A1 of the optics 100. The second internal total reflection part 120 has a second ridge part 121 on the side facing the first internal total reflection part 110. Note that the side of the second internal total reflection part 120 facing the first internal total reflection part 110 can be expressed as the Z+ side and the inside (center C0) side of the optics 100.

The second ridge part 121 is disposed in the second internal total reflection part 120 so as to extend radially from the central axis A1. In addition, a plurality of second ridge parts 121 is provided adjacent to each other. That is, the second ridge parts 121 adjacent to each other constitute a second trough part 125. This can also be expressed as follows: a pair of second trough parts 125 are provided on both sides with the second ridge part 121 being interposed therebetween.

Hereinafter, a virtual plane defined by a second bottom 126 of the pair of second trough parts 125 is defined as a second imaginary surface 128. In the present embodiment, the second imaginary surface 128 includes the second bottom 126 of all the second trough parts 125 existing in the second internal total reflection part 120. Note that the second bottom 126 can also be expressed as a boundary between second ridge parts 121 adjacent to each other.

The second ridge part 121 includes a third total reflection surface 122 having a third angle θ3 with respect to the second imaginary surface 128, and a fourth total reflection surface 123 having a fourth angle θ4 with the third total reflection surface 122. Note that the fourth angle θ4 corresponds to an apex angle of the second ridge part 121. In addition, an intersection line of the third total reflection surface 122 or the fourth total reflection surface 123 and the second imaginary surface 128 corresponds to the second bottom 126. In other words, the second bottom 126 corresponds to an intersection line of the third total reflection surface 122 of one second ridge part 121 and the fourth total reflection surface 123 of the other second ridge part 121 adjacent to the one second ridge part 121. In addition, the intersection line of the third total reflection surface 122 and the fourth total reflection surface 123 corresponds to a second top 124 of the second ridge part 121.

The second ridge part 121 defined as described above has an inverted V-shaped cross-sectional shape in a virtual cross-section orthogonal to the second bottom 126 and the second imaginary surface 128. In addition, the second ridge part 121 is convex in a direction (Z-direction) away from the center C0 of the optics 100. That is, the intersection lines of the virtual cross-section, and the second imaginary surface 128, the third total reflection surface, and the fourth total reflection surface constitute an isosceles triangle on the virtual cross-section. At this time, the third angle θ3 and the fourth angle θ4 are each one of the interior angles of the isosceles triangle. However, in the present embodiment, it is assumed that a length of the intersection line of the virtual cross-section, and the third total reflection surface 122 and the fourth total reflection surface 123 is equal on the virtual cross-section.

The cross-sectional shape of the second ridge part 121 defined as described above changes according to the distance from the central axis A1 (second total reflection surface 113 or peripheral total reflection surface 119). That is, the distance between the second top 124 of the second ridge part 121 and the second imaginary surface 128 is larger as the distance from the central axis A1 increases. This can be expressed as follows: as the distance from the central axis A1 increases, the height of the second ridge part 121 increases, or the widths of the third total reflection surface 122 and the fourth total reflection surface 123 increase. Here, the width of the third total reflection surface 122 or the fourth total reflection surface 123 is a distance between the second top 124 of the second ridge part 121 and the second bottom 126 of the second trough part 125 adjacent to the second ridge part 121. On the other hand, it is assumed that the apex angle (fourth angle θ4) of the second ridge part 121 is constant regardless of the distance from the central axis A1.

Here, when the width of the first ridge part 111 is defined as the distance between the pair of first trough parts 115 and the width of the second ridge part 121 is defined as the distance between the pair of second trough parts 125, the width of the first ridge part 111 is smaller than the width of the second ridge part 121. This can be expressed as follows: the apex angle (second angle θ2) of the first ridge part 111 is smaller than the apex angle (fourth angle θ4) of the second ridge part 121.

As described above, the second ridge part 121 according to the present embodiment is positioned on the second imaginary surface 128. The second imaginary surface 128 has a shape dented in a substantially conical shape on the outer side (Z- side) of the optics 100. At this time, the center of the second imaginary surface 128 remains positioned on the central axis A1.

From the configuration described above, the angle of the third total reflection surface 122 with respect to the incidence plane of the incidence part 130 is expressed by the sum of the angle of the second imaginary surface 128 (second bottom 126) with respect to the incidence plane of the incidence part 130 and the third angle θ3. Note that the angle of the third total reflection surface 122 of the second internal total reflection part 120 may be set with respect to the second total reflection surface 113 or the peripheral total reflection surface 119 of the first internal total reflection part 110. As described above, the cross-sectional shape of the second ridge part 121 changes according to the distance from the light source 200 (central axis A1).

As illustrated in FIG. 6, the emission part 140 according to the present embodiment faces the second internal total reflection part 120. In addition, the emission part 140 is positioned around the first ridge part 111 of the first internal total reflection part 110. That is, the peripheral total reflection surface 119 according to the present embodiment can also be expressed as functioning as the incidence plane of the emission part 140 with respect to the light beams internally totally reflected by the second internal total reflection part 120. The light beams internally totally reflected by the second internal total reflection part 120 are incident on the incidence plane (peripheral total reflection surface 119) of the emission part 140 at an angle smaller than the critical angle θc.

Here, the operation of the lighting device 1 according to the present embodiment will be described with reference to the drawings. As illustrated in FIG. 8, in the optics 100 according to the present embodiment, the central axis A1 passes through the center C0 of the optics 100, the center P0 of the incidence part 130, the center P1 of the first internal total reflection part 110, and the center P2 of the second internal total reflection part 120. In addition, the light source 200 is disposed so that the center P3 of the light source 200 is positioned on the central axis A1. The ray emitted from the light emitting surface of the light source 200 irradiates the incidence part 130. The light beam is incident on the interior of the optics 100 from the incidence part 130. The light beams incident on the inside of the optics 100 pass through the inside of the optics 100 and reach the first internal total reflection part 110. The light beams are internally totally reflected by the first ridge part 111 or the peripheral total reflection surface 119 of the first internal total reflection part 110. The light beams totally reflected by the second total reflection surface 113 or the peripheral total reflection surface 119 pass through the inside of the optics 100 again and reach the second internal total reflection part 120.

The light beams reaching the second internal total reflection part 120 are incident on the third total reflection surface 122. At this time, the third angle θ3 is set so that the light beams incident from the first internal total reflection part 110 can be incident on the third total reflection surface 122 at an angle equal to or larger than the critical angle θc. In addition, the fourth angle θ4 (apex angle of the second ridge part 121) is set so that the light beams totally reflected by the third total reflection surface 122 are incident on the fourth total reflection surface 123 at an angle equal to or larger than the critical angle θc.

With such a configuration, as illustrated in FIGS. 6 to 8, the light beams are continuously totally reflected on the third total reflection surface 122 and the fourth total reflection surface 123. Therefore, the light beams incident on the second internal total reflection part 120 from the first internal total reflection part 110 are folded back in the second internal total reflection part 120, without absorption loss such as reflection by mirror. In addition, the light beams folded in the second internal total reflection part 120 are incident on the incidence plane of the emission part 140 at an angle equal to or smaller than the critical angle θc, and are emitted from the emission part 140 to the outside of the optics 100.

As described above, the light beam emitted from the optics 100 according to the present embodiment is a light beam of narrow light distribution having a small angle with respect to the central axis A1. The angle formed between the light beam and the central axis A1 is 90 degrees or less. In addition, the first internal total reflection part 110, the second internal total reflection part 120, and the emission part 140 are designed so that the angle formed by the light beam emitted to the outside of the optics 100 and the central axis A1 becomes small. Therefore, the lighting device 1 according to the present embodiment can realize illumination with narrow light distribution.

According to the optics 100 and the lighting device 1 including the optics 100 according to the present embodiment, the following can be said.

The optics 100 according to the present embodiment further includes a second internal total reflection part 120 that faces the first internal total reflection part 110 so that the light beams internally totally reflected by the first internal total reflection part 110 are internally totally reflected. The second internal total reflection part 120 includes a second ridge part 121 extending radially from the central axis A1. The cross-sectional shape of the second ridge part 121 changes according to the distance from the central axis A1. With such a configuration, the light beams internally totally reflected by the first internal total reflection part 110 can be further internally totally reflected and the direction of the light beams can be folded. Therefore, the size of the optics 100 with respect to the optical path length can be reduced. Therefore, the use of the optics 100 according to the present embodiment can make the lighting device 1 compact. For example, the conventional optics that reflects the light beam by using the mirror is required to have the height of about 105 times the width of the light emitting surface of the light source so as to realize the light distribution angle of 10 degrees. Here, the width of the light emitting surface is the length of the light emitting surface on the X-Y plane, and the height is the length of the reflecting mirror in the Z direction. On the other hand, in the lighting device 1 using the optics 100 according to the present embodiment, the height of the optics 100 in the Z direction may be about five times the width of the light emitting surface of the light source 200.

In the optics 100 according to the present embodiment, the apex angle (second angle θ2) of the first ridge part 111 is smaller than the apex angle (fourth angle θ4) of the second ridge part 121. With such a configuration, the light beams internally totally reflected by the first internal total reflection part 110 can be further internally totally reflected properly. In addition, with such a configuration, since the light beam path can be appropriately folded by the internal total reflection, the angle formed by the light beam emitted from the emission part 140 and the central axis A1 can be reduced.

In the optics 100 according to the present embodiment, the second internal total reflection part 120 includes the pair of second trough parts 125 on both sides with the second ridge part 121 being interposed therebetween. The second ridge part 121 includes the third total reflection surface 122 having the third angle θ3 with respect to the second imaginary surface 128 defined by the second bottom 126 of the pair of second trough parts 125, and the fourth total reflection surface 123 having the fourth angle θ4 with respect to the third total reflection surface 122. With such a configuration, it is possible to properly realize two consecutive internal total reflections in the second internal total reflection part 120.

In the optics 100 according to the present embodiment, the second imaginary surface 128 has an apex on the central axis A1 and is recessed in a substantially conical shape on the outer side (Z- side) of the optics 100. The concept of the substantially conical shape referred to here includes a conical shape such as a cone or a polygonal pyramid, a spindle shape, and the like. With such a configuration, the light beams internally totally reflected by the first internal total reflection part 110 are incident on the third total reflection surface 122 at an incidence angle exceeding the critical angle θc with respect to the third total reflection surface.

In the optics 100 according to the present embodiment, the second top 124 of the second ridge part 121 is the intersection line of the third total reflection surface 122 and the fourth total reflection surface 123, and the length from the second top 124 to the second imaginary surface 128 increases with the distance from the central axis A1. With such a configuration, it is possible to properly realize two consecutive internal total reflections in the second internal total reflection part 120.

In the optics 100 according to the present embodiment, the third angle θ3 is set so that the incidence angle of the light beams internally totally reflected by the first internal total reflection part 110 with respect to the third total reflection surface 122 exceeds the critical angle θc. With such a configuration, the light beams internally totally reflected by the first internal total reflection part 110 are incident on the third total reflection surface 122 at an incidence angle exceeding the critical angle θc with respect to the third total reflection surface.

In the optics 100 according to the present embodiment, the fourth angle θ4 is constant, and the fourth angle θ4 is set so that the light beams totally reflected by the third total reflection surface 122 are further totally reflected on the fourth total reflection surface 123. That is, the fourth angle θ4 is set so that the incidence angle of the light beams totally reflected by the third total reflection surface 122 to the fourth total reflection surface 123 exceeds the critical angle θc. With such a configuration, it is possible to properly realize two consecutive internal total reflections in the second internal total reflection part 120.

In the optics 100 according to the present embodiment, the first ridge part 111 is provided in a range within a predetermined distance from the central axis A1 in the first internal total reflection part 110. With such a configuration, a part of the first internal total reflection part 110 can be used as the emission part 140 according to the incidence angle of the light beams incident on the first internal total reflection part 110. In addition, as compared with the case where the first ridge part 111 is provided on the entire surface of the first internal total reflection part 110, the processing cost can be reduced.

The optics 100 according to the present embodiment further includes a blind hole 150. With such a configuration, when the optics 100 is used for the lighting device 1, the blind hole 150 can be used as a heat dissipation part. That is, when the blind hole 150 is provided, the deformation or damage of the optics 100, the damage of the light source 200, and the like due to heat generation of the light source 200 can be reduced. In addition, the material cost can be reduced according to the size of the blind hole 150.

(Third Embodiment)

Hereinafter, the lighting device 1 according to the present embodiment will be described in detail with reference to the drawings. Here, the difference from the second embodiment will be mainly described, the same parts will be denoted by the same reference numerals, and description thereof will be omitted.

In the second embodiment, the compact lighting device 1 with high instrument efficiency, which can realize illumination with narrow light distribution, has been described. In such a lighting device, a plurality of LEDs or the like may be used as the light source 200. On the other hand, there are individual differences in LED emission intensity or color development. In addition, there is also a demand for a technique for mixing colors of illumination light emitted from light sources such as LEDs capable of emitting different colors. Under such circumstances, particularly in medical illumination, color uniformity of the illumination light on the irradiated surface is required.

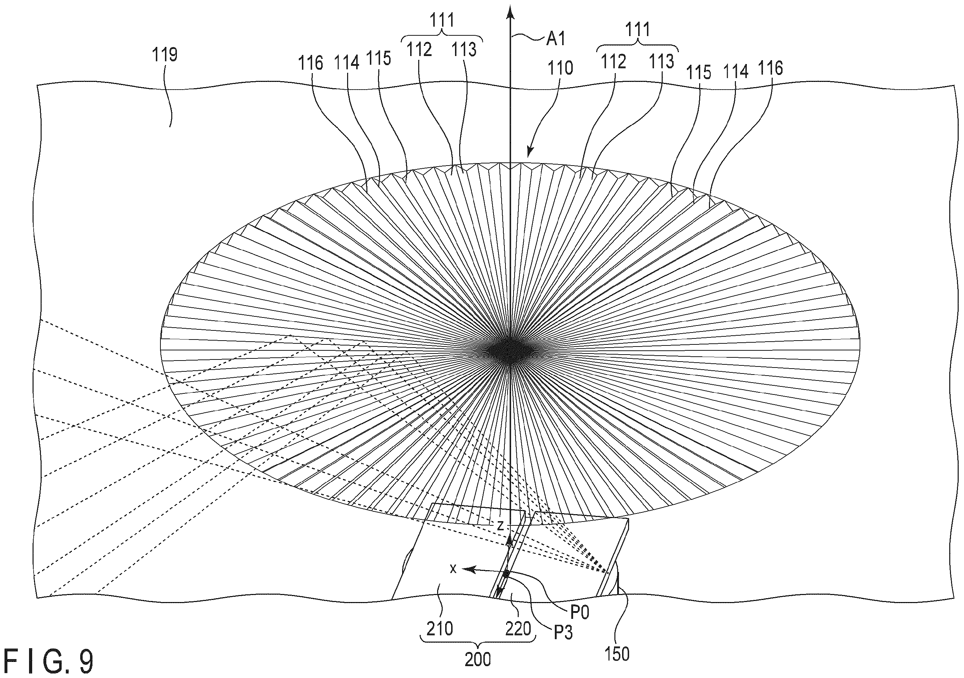

Therefore, in the present embodiment, color mixture of illumination light by the lighting device 1 including the optics 100 according to the second embodiment and the light source 200 including a plurality of light emitting elements will be described. An example of the configuration and arrangement of the light source 200 according to the present embodiment is illustrated in FIG. 9. In FIG. 9, in addition to an example of the configuration and arrangement, an example of the light beam path is schematically illustrated.

As illustrated in FIG. 9, the light source 200 according to the present embodiment includes a blue light emitting diode (blue LED 210) and a red light emitting diode (red LED 220). Each of the blue LED 210 and the red LED 220 has a shape and size obtained by roughly dividing the light source 200 into two parts, and has a light emitting surface on the side facing the first internal total reflection part 110. The blue LED 210 is disposed on the X+ side in the light source 200. The red LED 220 is disposed on the X- side in the light source 200.

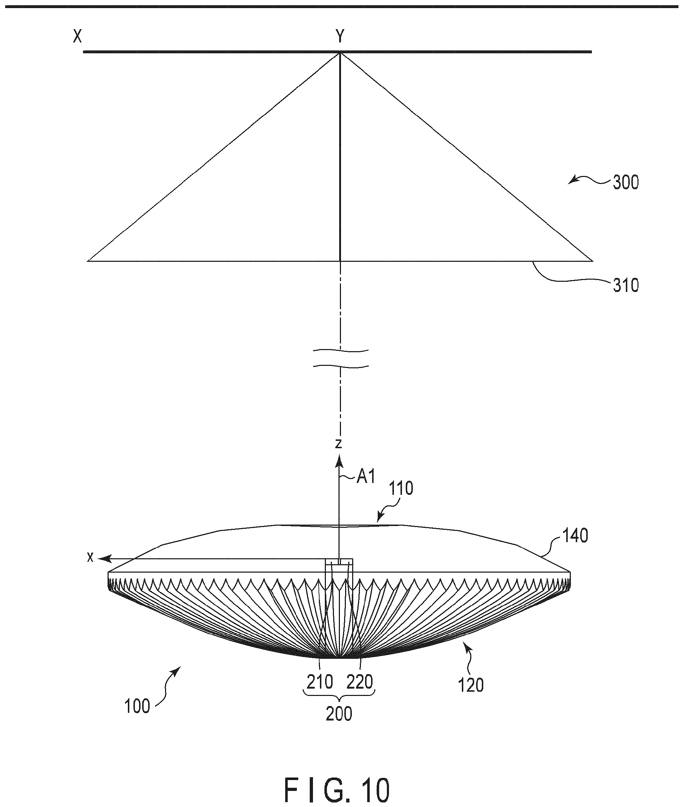

Here, FIG. 10 schematically illustrates an analysis model for analyzing the color mixture of the illumination light by the lighting device 1 according to the present embodiment. As illustrated in FIG. 10, in the present analysis model, the illuminance distribution is analyzed for the illumination light irradiating an irradiated surface 310 of a receiver 300 disposed at a predetermined distance from the lighting device 1. In addition, the center of the irradiated surface 310 is disposed on the central axis A1 of the lighting device 1.

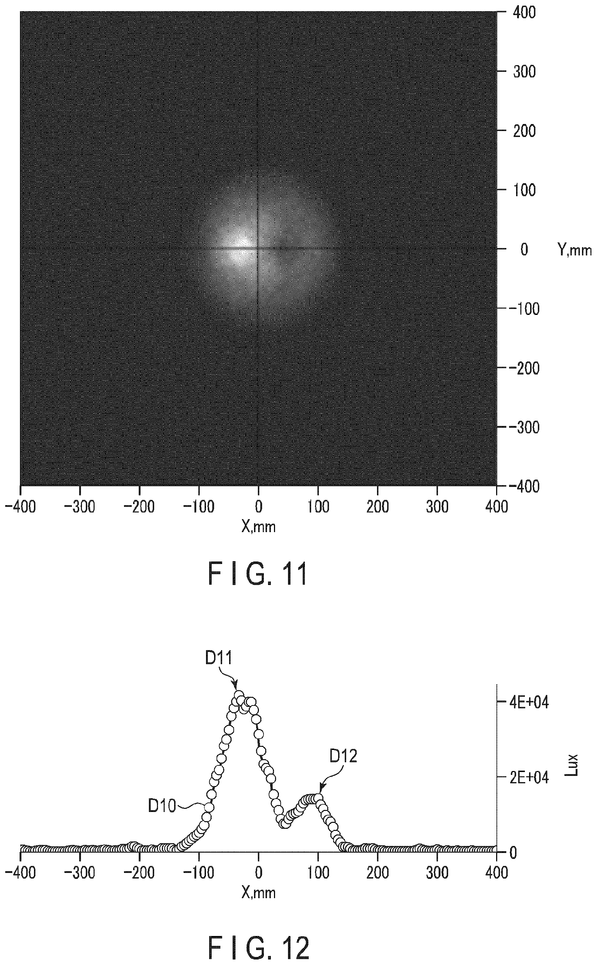

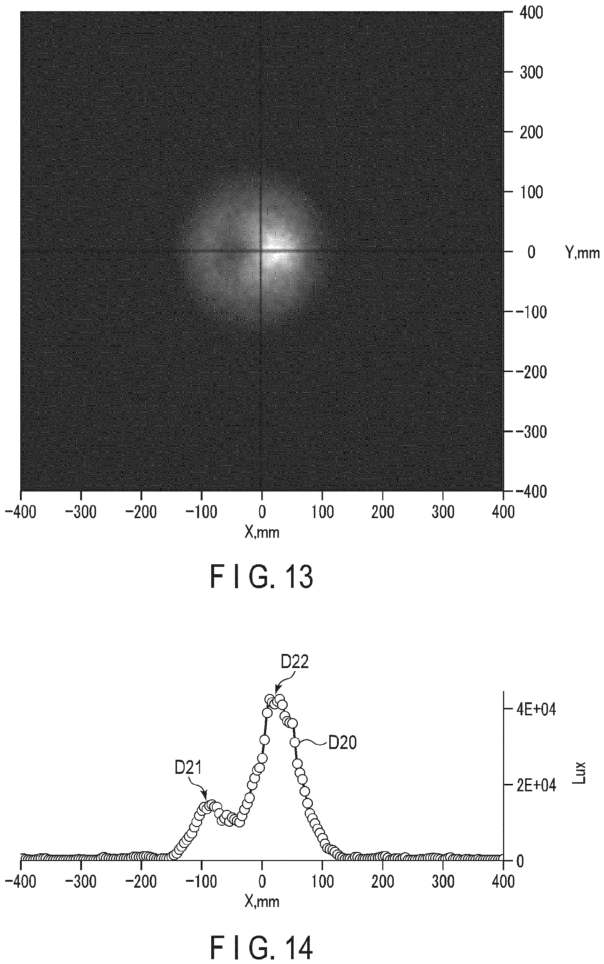

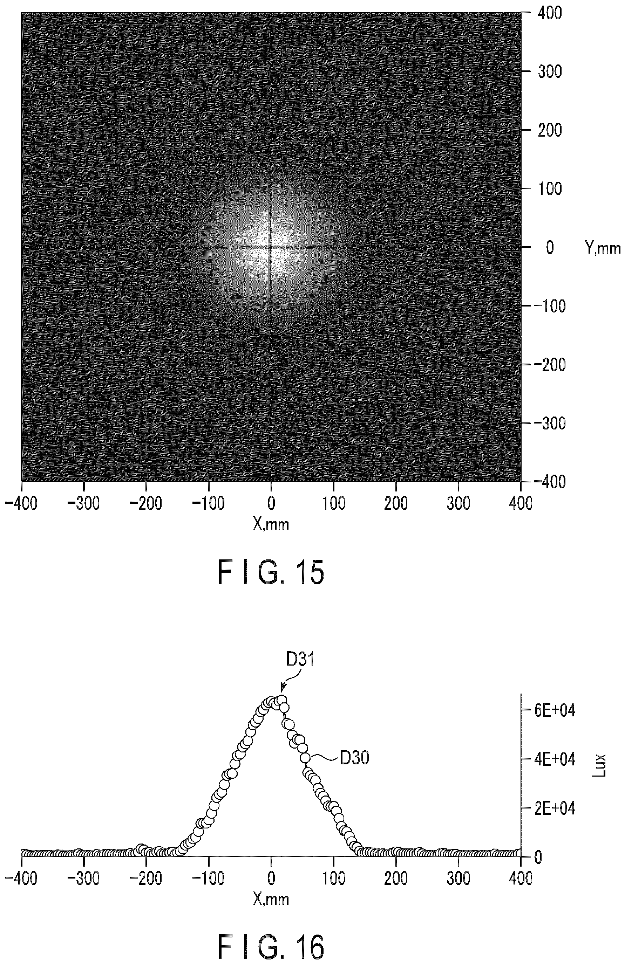

The illuminance distribution obtained by the analysis using the analysis model illustrated in FIG. 10 will be described with reference to the drawings. Here, FIG. 11 illustrates the illuminance distribution on the irradiated surface 310 when the illumination light is emitted from the blue LED 210. In addition, FIG. 12 illustrates the illuminance with respect to the position in the X direction at the position Y = 0 mm in the illuminance distribution illustrated in FIG. 11. FIG. 13 illustrates the illuminance distribution on the irradiated surface 310 when the illumination light is emitted from the red LED 220. In addition, FIG. 14 illustrates the illuminance with respect to the position in the X direction at the position Y = 0 mm in the illuminance distribution illustrated in FIG. 13. FIG. 15 illustrates the illuminance distribution on the irradiated surface 310 when the illumination light is emitted from each of the blue LED 210 and the red LED 220. In addition, FIG. 16 illustrates the illuminance with respect to the position in the X direction at the position Y = 0 mm in the illuminance distribution illustrated in FIG. 15. In FIGS. 11, 13, and 15, the vertical axis represents the position in the Y direction on the irradiated surface 310, and the horizontal axis represents the position in the X direction in the irradiated surface 310. In addition, in FIGS. 11, 13, and 15, the position indicating high illuminance is displayed in white, and the position indicating low illuminance is displayed in black. Note that, in FIG. 12, 14, and 16, the vertical axis represents the illuminance in Lux units, and the horizontal axis represents the position in the X direction.

As illustrated in FIGS. 11 and 12, when illumination light is emitted from the blue LED 210, it can be seen that deviation occurs in the peak position in the illuminance distribution. In this case, for example, as illustrated in FIG. 12, a first maximum value D11 and a second maximum value D12 exist in an illuminance distribution D10. Similarly, as illustrated in FIGS. 13 and 14, even when illumination light is emitted from the red LED 220, it is understood that the peak position in the illuminance distribution is deviated. In this case, for example, as illustrated in FIG. 13, a third maximum value D21 and a fourth maximum value D22 exist in the illuminance distribution D20.

On the other hand, as illustrated in FIGS. 15 and 16, when illumination light is emitted from each of the blue LED 210 and the red LED 220, it is understood that there is no deviation in the peak position in the illuminance distribution. At this time, since the optics 100 according to the present embodiment has a rotationally symmetrical shape with respect to the central axis A1, the first maximum value D11 and the third maximum value D21 are approximately the same position. Similarly, the second maximum value D12 and the fourth maximum value D22 are substantially the same position. In this case, for example, as illustrated in FIG. 16, in the illuminance distribution D30, there is a single maximum value in the vicinity of the position X = Y = 0, that is, the maximum value D31. As described above, when illumination light is emitted from each of the blue LED 210 and the red LED 220, the spot-shaped illuminance distribution is obtained.

The optics 100 according to the present embodiment folds the light beam path by using the internal total reflection. Therefore, the use of the optics 100 according to the present embodiment can lengthen the optical path length of the illumination light emitted from the light emitting surface of the light source 200. In addition, the light beams emitted from the light source are internally totally reflected by the plurality of first ridge parts according to the direction emitted from the light emitting surface, and are further internally totally reflected by the plurality of second ridge parts. That is, when the optics 100 according to the present embodiment is used, the light source can be regarded as a point light source, and most of the light beam paths intersect with each other. Therefore, the optics 100 according to the present embodiment can mix light beams emitted from the plurality of light sources with the irradiated surface.

From the above, it can be seen that the illumination light is mixed in the irradiated surface 310 even when the blue LED 210 and the red LED 220 are spaced apart from each other and each emit light. As described above, the lighting device 1 according to the present embodiment can mix colors of illumination light emitted from the plurality of light sources on the irradiated surface 310.

Note that, in the present embodiment, the case where the colors of the illumination light emitted from the plurality of light emitting elements included in the light source 200 are different has been described as an example, but the present invention is not limited thereto. For example, the colors of the illumination light emitted from the plurality of light emitting elements may be the same. In this case, the lighting device 1 according to the present embodiment can reduce color unevenness caused by the individual differences of the light emitting elements.

(Fourth Embodiment)

Hereinafter, the condenser according to the present embodiment will be described with reference to FIGS. 1, 6, 8, and the like. Here, the difference from the first embodiment will be mainly described, the same parts will be denoted by the same reference numerals, and description thereof will be omitted. In the present embodiment, although a part of the configuration is different from FIG. 1 of the first embodiment and FIGS. 6 and 8 of the second embodiment, these drawings will be used in the following description.

In the first embodiment and the second embodiment, the optics 100 capable of folding the light beam path without substantial energy loss by the internal total reflection of the light beams incident from the incidence part 130 has been described. As described above, when used in the lighting device 1, the optics 100 can increase or decrease the light distribution angle of the illumination light. For example, the light beam direction of the light beam emitted from the emission part 140 of the optics 100 according to the first embodiment has a large angle with the central axis A1.

On the other hand, when such optics 100 is used in the condenser, it is possible to increase or decrease the light direction (convergence angle) of the light beam that can be concentrated. For example, the light beams incident from the emission part 140 of the optics 100 according to the first embodiment and the second embodiment are internally totally reflected inside the optics 100 and reach the incidence part 130. Therefore, in the present embodiment, the condenser capable of concentrating light with high efficiency by internally totally reflecting the incident light beam will be described.

The condenser according to the present embodiment includes the optics 100 according to the first embodiment and a solar cell.

In the condenser according to the present embodiment, the emission part 140 of the optics 100 according to the first embodiment is used as a sunlight incidence part. In addition, the incidence part 130 of the optics 100 according to the first embodiment is used as a sunlight emission part. That is, the first internal total reflection part 110 and the sunlight emission part face each other. The solar cell is disposed at the position of the light source 200 according to the first embodiment. That is, the light concentrating surface of the solar cell is disposed at a position facing the first internal total reflection part 110.

The light beams incident from the sunlight incidence part (emission part 140) to the inside of the optics 100 pass through the inside of the optics 100 and reach the first internal total reflection part 110. The light beams reaching the first internal total reflection part 110 are internally totally reflected twice in the first ridge part 111. The light beams internally totally reflected by the first internal total reflection part 110 reach the sunlight emission part (incidence part 130).

The condenser according to the present embodiment includes the optics 100 according to the first embodiment and a solar cell. With such a configuration, the light beams incident on the first internal total reflection part 110 from the sunlight incidence part (emission part 140) are folded back in the first internal total reflection part 110, without absorption loss such as reflection by mirror. In addition, the light beams folded in the first internal total reflection part 110 are emitted from the sunlight emission part (incidence part 130). As described above, the light beam concentrated by the optics 100 according to the present embodiment is a light beam with a wide light concentration angle having a large angle with the central axis A1. The angle formed by the light beam that can be concentrated and the central axis A1 is 90 degrees or more.

In addition, in the condenser according to the present embodiment, the sunlight emission part (incidence part) 130 and the first internal total reflection part 110 face each other. With such a configuration, by using the optics 100 according to the first embodiment, the light beams incident from the sunlight incidence part (emission part 140) can be concentrated to the sunlight emission part (incidence part 130) with high efficiency.

In addition, in the condenser according to the present embodiment, the angle between the central axis A1 and the light beam incident to the sunlight incidence part (emission part 140) can be larger than the angle between the central axis A1 and the light beam emitted from the sunlight emission part (incidence part 130). That is, by using the condenser according to the present embodiment, sunlight can be concentrated with a large convergence angle.

Note that, in the present embodiment, the condenser including the solar cell has been described, but the present invention is not limited thereto. For example, it is possible to realize a high-efficiency heat collecting device including an optics 100 and a heat storage part.

Note that, in the present embodiment, the condenser including the optics 100 according to the first embodiment has been described, but the present invention is not limited thereto. For example, it may be a condenser including the optics 100 according to the second embodiment. In this case, light beams emitted from a specific light source can be selectively concentrated with high efficiency.

Note that, in the present embodiment, the case where the sunlight incident on the sunlight incidence part (emission part 140) is concentrated has been described as an example, but the present invention is not limited thereto. The same effects can be obtained even if the light beams to be concentrated are light beams emitted from the light source other than the sunlight.

(First Modification)

Hereinafter, the modification according to the first embodiment will be described. Here, the difference from the first embodiment will be mainly described, the same parts will be denoted by the same reference numerals, and description thereof will be omitted.

The technique according to the first embodiment can be applied to the optics for totally reflecting the light beam by the reflecting mirror. That is, the absorption of light beams by the reflecting mirror can be suppressed by applying the first internal total reflection part 110 instead of the reflecting mirror.

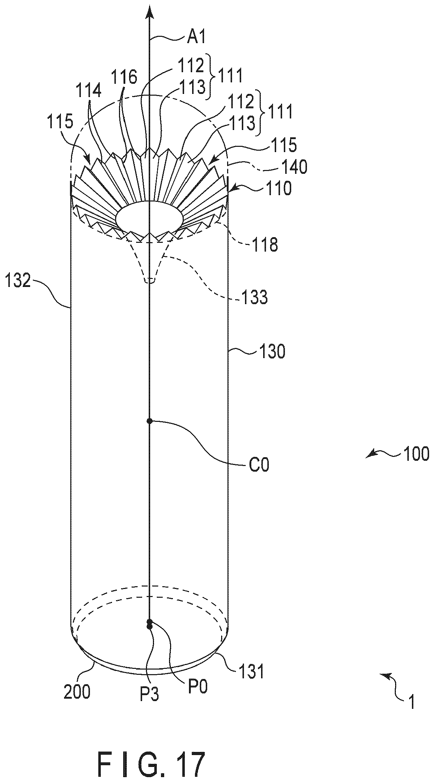

FIG. 17 illustrates an example of the lighting device 1 to which the technique according to the first embodiment is applied. The lighting device 1 according to the present embodiment includes an optics 100 and a light source 200.

An incidence part 130 of the optics 100 according to the present embodiment includes a light source side incidence surface 131 on which light beams are incident from the light source 200, a cylindrical light guide part 132 which guides light beams to an emission part 140, and an inner incidence surface 133. The inner incidence surface 133 has a shape recessed in a conical shape on the center C0 side of the optics 100.

A first internal total reflection part 110 according to the present embodiment internally totally reflects light beams incident from the inner incidence surface 133. However, in the optics 100 according to the present embodiment, a first imaginary surface 118 and the incidence part 130 do not face each other. As illustrated in FIG. 17, both the first imaginary surface 118 and the inner incidence surface 133 have a conical shape recessed toward the center C0 of the optics 100. Therefore, in the optics 100 according to the present embodiment, the light beams incident from the inner incidence surface 133 are incident on the first total reflection surface 112 of the first ridge part 111 positioned on the opposite sides with the central axis A1 being interposed therebetween. Therefore, the first angle θ1 of the first total reflection surface 112 is set with respect to the angle of the inner incidence surface 133.

The light beams incident on the first internal total reflection part 110 according to the present embodiment are emitted to the outside from the emission part 140 after two consecutive internal total reflections. At this time, the angle formed by the light beam emitted from the emission part 140 to the outside and the central axis A1 is larger than the angle formed by the light beam incident on the light source side incidence surface 131 and the central axis A1. As described above, the lighting device 1 using the optics 100 according to the present embodiment can realize illumination with wide light distribution with high instrument efficiency.

Note that one embodiment can also be realized by appropriately combining the respective embodiments and modifications described above. For example, in the condenser of the fourth embodiment, the optics 100 according to the first embodiment, the second embodiment, or the first modification can be combined.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

**Claims**

1. An optics **characterized by** comprising:

   an incidence part (130) where a light beam enters;
   a first internal total reflection part (110) which internally totally reflects the light beam from the incidence part; and

   an emission part (140) where the light beam internally totally reflected by the first internal total reflection part (110) is emitted,
   wherein the first internal total reflection part (110) includes a first ridge part (111) which extends radially from a central axis (A1) of the optics, and
   a cross-sectional shape of the first ridge part (111) changes according to a distance from the central axis (A1).

2. The optics according to claim 1, wherein the first internal total reflection part (110) further includes a pair of first trough parts (115) on both sides with the first ridge part (111) being interposed therebetween, and the first ridge part (111) comprises:

   a first total reflection surface (112) having a first angle with respect to a first imaginary surface (118) defined by a first bottom of the pair of first trough parts (115); and
   a second total reflection surface (113) having a second angle with respect to the first total reflection surface (112).

3. The optics according to claim 2, wherein a first top (114) of the first ridge part (111) is an intersection line of the first total reflection surface (112) and the second total reflection surface (113), and a length from the first top (114) to the first imaginary surface (118) increases with a distance from the central axis (A1).

4. The optics according to claim 2, wherein the first imaginary surface (118) has an apex on the central axis (A1) and is recessed in a substantially conical shape on the center side of the optics.

5. The optics according to claim 2, wherein the first angle is set so that an incidence angle of the light beam incident from the incidence part (130) with respect to the first total reflection surface (112) exceeds a critical angle.

6. The optics according to claim 2, wherein the second angle is constant, and the second angle is set so that the light beam totally reflected by the first total reflection surface (112) is further totally reflected on the second total reflection surface (113).

7. The optics according to claim 1, further comprising a second internal total reflection part (120) which faces the first internal total reflection part (110) so that the light beam internally totally reflected by the first internal total reflection part (110) is internally totally reflected, wherein the second internal total reflection part (120)

includes a second ridge part (121) which extends radially from the central axis (A1), and
a cross-sectional shape of the second ridge part (121) changes according to a distance from the central axis (A1).

8. The optics according to claim 7, wherein an apex angle of the first ridge part (111) is smaller than an apex angle of the second ridge part (121).

9. The optics according to claim 7, wherein the second internal total reflection part (120) has a pair of second trough part (125) on both sides the second ridge part (121) being interposed therebetween, and
the second ridge part (121) comprises:

a third total reflection surface (122) having a third angle with respect to a second imaginary surface (128) defined by a second bottom of the pair of second trough parts (125); and
a fourth total reflection surface (123) having a fourth angle with respect to the third total reflection surface (122).

10. The optics according to claim 9, wherein the second imaginary surface (128) has an apex on the central axis (A1) and is recessed in a substantially conical shape in the outside of the optics.

11. The optics according to claim 9, wherein a second top (124) of the second ridge part (121) is an intersection line of the third total reflection surface (122) and the fourth total reflection surface (123), and
a length from the second top (124) to the second imaginary surface (128) increases with a distance from the central axis (A1).

12. The optics according to claim 9, wherein the third angle is set so that an incidence angle of the light beam internally totally reflected by the first internal total reflection part (110) with respect to the third total reflection surface (122) exceeds a critical angle.

13. The optics according to claim 9, wherein the fourth angle is constant, and
the fourth angle is set so that the light beam totally reflected by the third total reflection surface (122) is further totally reflected on the fourth total reflection surface (123).

14. A lighting device **characterized by** comprising:

the optics according to claim 1; and
a light source (200),
wherein the incidence part (130) and the first internal total reflection part (110) face each other.

15. The lighting device according to claim 14, wherein the light source (200) is an LED.

16. The lighting device according to claim 14, wherein an angle between the central axis (A1) and the light beam incident on the incidence part (130) is smaller than an angle between the central axis (A1) and the light beam emitted from the emission part (140).

17. A condenser **characterized by** comprising:

the optics according to claim 1; and
a solar cell ,
wherein the emission part (140) and the first internal total reflection part (110) face each other.

18. The condenser according to claim 17, wherein an angle between the central axis (A1) and the light beam incident on the incidence part (130) is larger than an angle between the central axis (A1) and the light beam emitted from the emission part (140).

A1

P1

111                                    111

110

140

111                                    118

115                                    111

200

P3    P0

100

1

# FIG. 1

A1

P1

114        111        111

116(118)                                110
114
116(118)

R2

R3                                      140

R2

R1

R3

200    P3    P0    C0    130

100

1

# FIG. 2

FIG.3

F I G. 4

F I G. 5

FIG.6

F I G. 7

FIG.8

FIG.9

EP 3 674 755 A1

FIG. 10

F I G. 11

F I G. 12

F I G. 13

F I G. 14

FIG. 15

FIG. 16

F I G. 17

**INTERNATIONAL SEARCH REPORT**

International application No.

PCT/JP2018/025370

**A. CLASSIFICATION OF SUBJECT MATTER**
Int.Cl. G02B5/00(2006.01)i, F21S2/00(2016.01)i, F21V5/00(2018.01)i,
H01L31/054(2014.01)i, H01L33/60(2010.01)i, H02S40/22(2014.01)i

According to International Patent Classification (IPC) or to both national classification and IPC

**B. FIELDS SEARCHED**

Minimum documentation searched (classification system followed by classification symbols)
Int.Cl. G02B5/00, F21S2/00, F21V5/00, H01L31/054, H01L33/60, H02S40/22

Documentation searched other than minimum documentation to the extent that such documents are included in the fields searched
Published examined utility model applications of Japan        1922-1996
Published unexamined utility model applications of Japan      1971-2018
Registered utility model specifications of Japan              1996-2018
Published registered utility model applications of Japan      1994-2018

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2012-48950 A (TOSHIBA LIGHTING & TECHNOLOGY CORPORATION) 08 March 2012, claims, paragraph [0021], fig. 1-6 (Family: none) | 1, 14-16 |
| X | JP 2016-219325 A (TOSHIBA LIGHTING & TECHNOLOGY CORPORATION) 22 December 2016, claims, paragraphs [0017], [0025]-[0031], [0047], fig. 1, 7 & CN 205424486 U | 1-6, 14-16 |
| Y | | 7-13, 17-18 |

☒ Further documents are listed in the continuation of Box C.      ☐ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 13.09.2018 | 25.09.2018 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

27

**INTERNATIONAL SEARCH REPORT**

International application No.

PCT/JP2018/025370

C (Continuation).    DOCUMENTS CONSIDERED TO BE RELEVANT

| Category* | Citation of document, with indication, where appropriate, of the relevant passages | Relevant to claim No. |
|---|---|---|
| X<br>Y | JP 2014-211983 A (STANLEY ELECTRIC CO., LTD.) 13 November 2014, claims, paragraphs [0030], [0069], fig. 7, etc.<br>& US 2014/0313758 A1, claims, paragraphs [0060], [0083], fig. 10, etc. & EP 2818789 A2 | 1-3, 5-6, 14-15<br>7-13 |
| X | JP 2017-79174 A (STANLEY ELECTRIC CO., LTD.) 27 April 2017, paragraphs [0021], [0023], [0028], [0032]<br>(Family: none) | 1, 14-15 |
| Y | JP 2015-99336 A (TOSHIBA CORPORATION) 28 May 2015, claims, paragraph [0003], fig. 3, 4<br>& US 2015/0140263 A1, claims, paragraph [0005], fig. 3, 4 & CN 104659138 A | 7-13, 17-18 |

Form PCT/ISA/210 (continuation of second sheet) (January 2015)